# EUROPÄISCHE PATENTANMELDUNG

(11) **EP 2 482 326 A2**
(43) Veröffentlichungstag der Anmeldung: **01.08.2012**
(21) Anmeldenummer: 12150464.1
(22) Anmeldetag: 09.01.2012
(51) Int. Cl.: H01L 31/02, H01L 31/05

(54) **Leistungshalbleiterelement und Anordnung eines Leistungshalbleiterelements zu mindestens einer Solarzelle**

(30) Priorität: 27.01.2011 DE 102011003284
(71) Anmelder: SEMIKRON Elektronik GmbH & Co. KG, 90431 Nürnberg (DE)
(72) Erfinder: Göbl, Christian, 90441 Nürnberg (DE); Halaj, Jan, 921 01 Piestany (SK); Mateicka, Marian, 956 07 Behynce (SK); Starovecky, Stefan, 921 01 Piestany (SK)

(57) **Zusammenfassung**

Die Anmeldung betrifft ein Leistungshalbleiterelement und dessen Anordnung zu mindestens einer Solarzelle. Das Leistungshalbleiterelement weist zum direkten Anschluss an Kontaktflächen der Solarzelle ein Kontaktelement und eine Kontaktfahne auf. Mit dem Kontaktelement ist mindestens ein Leistungshalbleiterbauelement mit dessen erster Chipkontaktfläche verbunden, während dessen zweite Chipkontaktfläche mit der Kontaktfahne verbunden ist. Zum Schutz gegen Umwelteinflüsse ist das mindestens eine Leistungshalbleiterbauelement in einer Umhausung eingeschlossen.

## Beschreibung

Die Erfindung beschreibt ein Leistungshalbleiterelement mit einem Kontaktelemente und einer Kontaktfahne zu dessen elektrischer Verbindung zu mindestens einer Solarzelle, sowie diese Anordnung als solche.

Beispielhaft aus der DE 103 48 542 A1 ist es bekannt eine Mehrzahl von Solarzellen, auch Photovoltaikzellen genannt, zu Photovoltaikmodulen zu verbinden. Hierbei ist pro Photovoltaikmodul mindestens eine Mehrzahl von Solarzellen in Reihe geschaltet, wodurch diese Mehrzahl sog. Stränge, oder Strings, ausbilden. Hierbei ist es bekannt dies mittels flächiger Metallformkörper, also mit Metallbändern, auszuführen, die mit zugeordneten Kontaktstellen der Solarzelle stoffschlüssig, mittels löten oder kleben, verbunden werden.

Grundsätzlich ist es aus der Reihenschaltung von Solarzellen bekannt, dass die Abschattung einer Zelle zur Unterbrechung des Solarstromes durch die in Reihe geschalteten Solarzellen führt. Ebenso ist es bekannt eine Bypassdiode der Solarzelle oder einer Mehrzahl von in Reihe geschalteten Solarzellen antiparallel zu schalten um einen Bypassstrompfad bereitzustellen.

Der Erfindung liegt die Aufgabe zugrunde ein besonders für die Verwendung in Photovoltaikmodulen geeignetes Leistungshalbleiterelement sowie dessen Anordnung zu mindestens einer Solarzelle vorzustellen.

Die Aufgabe wird erfindungsgemäß gelöst, durch ein Leistungshalbleiterelement mit den Merkmalen des Anspruchs 1 und durch eine Anordnung mit den Merkmalen des Anspruchs 10. Bevorzugte Ausführungsformen sind in den jeweiligen abhängigen Ansprüchen beschrieben.

Ausgangspunkt der Erfindung ist die Forderung ein Leistungshalbleiterelement zur Anordnung zu mindestens einer Solarzelle vorzustellen, das insbesondere eine besonders gute Kühlung des Leistungshalbleiterbauelements aufweist und gleichzeitig möglichst gut in den Fertigungsprozess von Photovoltaikmodulen integrierbar ist.

Das erfindungsgemäße Leistungshalbleiterelement zum direkten Anschluss an Kontaktflächen einer Solarzelle weist ein Kontaktelement auf, das auf seiner ersten Hauptfläche mindestens ein Leistungshalbleiterbauelement trägt, das hier mittels bekannter Verfahren, vorzugsweise stoffschlüssig, mit diesem verbunden ist. Im Folgenden wird das Leistungshalbleiterelement mit nur einem Leistungshalbleiterbauelement beschrieben, die Verallgemeinerung auf eine Mehrzahl von Leistungshalbleiterbauelementen ergibt sich durch fachübliches Handeln. Das Leistungshalbleiterbauelement kann hierbei eine Schottky- oder eine reine Halbleiterdiode mit einem pn- Übergang sein. Es ist bevorzugt, wenn die erste Chipkontaktfläche, die mit dem Kontaktelement verbunden ist, als diejenige der Anode der Diode ausgebildet ist.

Die zweite Hauptfläche des Kontaktelements weist mindestens eine erste Kontaktfläche zur ebenfalls bevorzugt stoffschlüssigen Verbindung mit einer zugeordneten Kontaktflächen der Solarzelle auf. Es ist hierbei bevorzugt, wenn diese Kontaktfläche der Solarzelle auf dessen der Sonne abgewandten Seite, der Rückseite, meist der Anode der Solarzelle, angeordnet ist.

Mit der zweiten Chipkontaktfläche, bevorzugt der Kathode der Diode, des Leistungshalbleiterbauelements ist eine Kontaktfahne, wiederum bevorzugt stoffschlüssig, verbunden. Diese Kontaktfahne weist ihrerseits eine zweite Kontaktfläche zur Verbindung mit einer zugeordneten Kontaktfläche einer Solarzelle auf. Diese zugeordnete Kontaktfläche kann derjenige Kathode derjenigen Solarzelle entsprechen auf der das Leistungshalbleiterelement angeordnet ist oder auch derjenigen Anode einer weiteren Solarzelle. Es ist besonders von Vorteil im Hinblick auf die Herstellung eines Photovoltaikmoduls, wenn die Kontaktfahne gleichartig den Metallbändern zur Verbindung der Solarzellen untereinander ausgebildet ist. Die Kontaktfahne und vorzugsweise auch das Kontaktelement können somit als Aluminiumband, meist mit einer zumindest teilflächig beschichteten Oberfläche, ausgebildet sein.

Weiterhin weist das Leistungshalbleiterelement eine Umhausung des mindestens einen Leistungshalbleiterbauelements auf. Unter Umhausung ist hierbei jegliche Ausgestaltung zu verstehen, die das Leistungshalbleiterbauelement gegen Umwelteinflüsse schützt. Diese Umhausung kann als ein Kunststoffgehäuse, das in bevorzugter Weise mit einem Isolationsstoff verfüllt ist ausgebildet sein. Es ist allerdings besonders bevorzugt um eine besonders kompakte Ausgestaltung der Umhausung zu ermöglichen, dass diese aus einem bei dessen Anordnung, also im Herstellungsprozess, fließfähigen Kunststoff besteht. Zu dieser Anordnung sind verschieden Verfahren, wie beispielsweise Abformverfahren, auch als Molding- Verfahren bezeichnet, bekannt.

Weiterhin ist es besonders bevorzugt, wenn das Kontaktelement im Vergleich zum Leistungshalbleiterbauelement großflächig ausgebildet ist um eine gute Kühlung des Leistungshalbleiterbauelements zu gewährleisten. Hierbei kann das Leistungshalbleiterbauelement maximal 10 von 100, vorteilhafterweise nur 5 von 100 der Fläche des Kontaktelements bedecken. Üblicherweise weist bei der oben beschriebenen Ausgestaltung der Kontaktfahne diese eine Länge auf, die mindestens das 5-fache, bevorzugt aber das 10-fach der Längsausdehnung des Leistungshalbleiterbauelements beträgt.

Auch ist es bevorzugt, wenn das Kontaktelement und die Kontaktfahne als Bänder ausgebildet sind, dass diese in Bezug auf ihre größte Längsausdehnung senkrecht zueinander angeordnet sind.

Die erfindungsgemäße Anordnung des Leistungshalbleiterelements zeichnet sich durch die oben beschriebene Anordnung auf der Rückseite der Solarzelle und die weiteren genannten Merkmale aus. Hierbei bildet die Verbindung der Kontaktfahne mit mindestens einer Kontaktfläche auf der Vorderseite der gleichen Solarzelle oder auf der Rückseite einer weiteren nicht zwangsläufig benachbarten Solarzelle einen Bypassstrompfad aus. Dieser überbrückt somit die eine Solarzelle oder die Mehrzahl von Solarzellen, um bei Beschattung dieser oder einer von diesen die Stromerzeugung des Strings zumindest begrenzt aufrecht zu erhalten.

Besonders vorteilhaft ist diese Anordnung, wenn das mindestens eine Leistungshalbleiterbauelement des Leistungshalbleiterelements nicht fluchtend über einer Kontaktfläche des Kontaktelements angeordnet ist und somit nicht in unmittelbar thermischen Kontakt zu der Solarzelle steht, sondern quasi über dieser schwebt.

Ebenso kann es vorteilhaft sein, wenn entweder das Kontaktelement, die Kontaktfahne oder beide eine vorzugsweise einstückig damit ausgebildete Kühleinrichtung aufweisen. Diese kann beispielhaft als oberflächenvergrößernde Prägung eines Abschnittes des Kontaktelements oder der Kontaktfahne ausgebildet sein. Es ist hierbei besonders bevorzugt, wenn diese Kühleinrichtung unmittelbar benachbart oder sogar direkt über oder unter dem Leistungshalbleiterbauelement vorgesehen ist.

Die erfinderische Lösung wird an Hand der Ausführungsbeispiele gemäß den Fig. 1 bis 7 weiter erläutert.

Fig. 1 zeigt in einem Ausschnitt ein Schaltbild eines Photovoltaikmoduls mit Bypassstrom pfad.

Fig. 2 zeigt die Rückseiten zweiter Solarzellen mit einem erfindungsgemäßen Leistungshalbleiterelement.

Fig. 3 zeigt zwei Solarzellen in Reihenschaltung.

Fig. 4 zeigt eine erste Ausgestaltung einer erfindungsgemäßen Anordnung eines Leistungshalbleiterelements.

Fig. 5 zeigt eine zweite Ausgestaltung einer derartigen Anordnung.

Fig. 6 zeigt eine erste Ausgestaltung eines erfindungsgemäßen Leistungshalbleiterelements.

Fig. 7 zeigt eine zweite derartige Ausgestaltung.

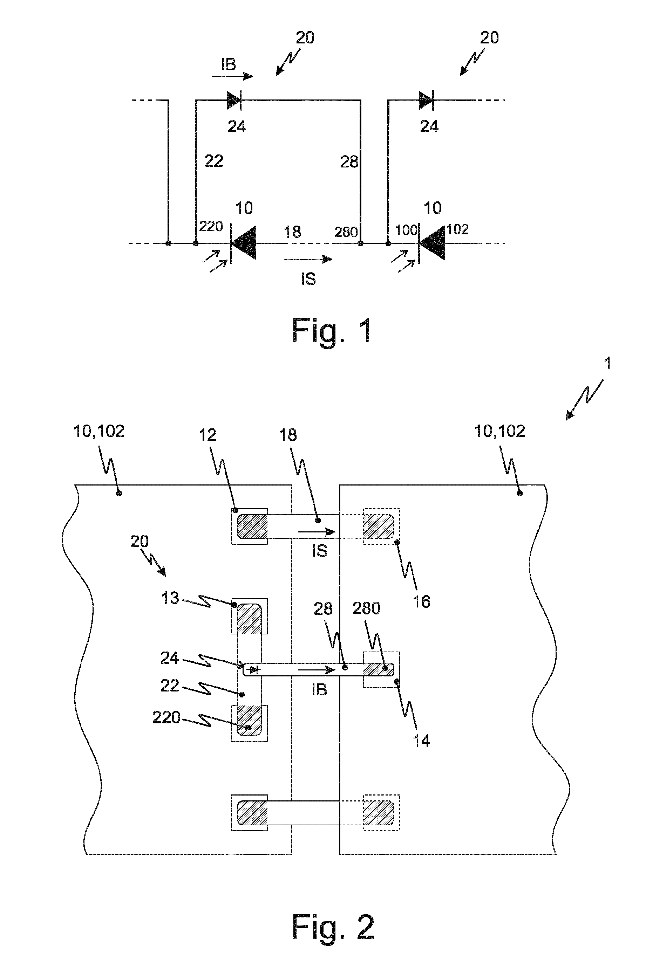

Fig. 1 zeigt in einem Ausschnitt ein Schaltbild eines Photovoltaikmoduls mit Bypassstrompfad. Dargestellt ist ein Teil eines Strings, also eine Mehrzahl von seriell geschalteten Solarzellen 10. Derartige Strings bilden eine typische Untereinheit eines Photovoltaikmoduls. Mit IS ist der Solarstrom der durch die Solarzellen 10 erzeugt wird bezeichnet. Parallel zu einer oder einer Mehrzahl von Solarzellen 10 ist jeweils ein erfindungsgemäßes Leistungsbauelement 20 mit der Funktion einer Bypassdiode dargestellt, wobei einzelne Leitungsabschnitte analog zu den Merkmalen in Fig. 2 bezeichnet sind. Dieser somit erzeugte Bypassstrompfad der Anordnung 1 wird aktiv, sobald eine der durch ihn überbrückten Solarzellen 10, z.B. durch Abschattung oder Defekt, keinen Strom erzeugt. In diesem Fall fließt der Strom durch den String an mindestens einer Stelle über den Bypassstrompfad mit dem Teilstrom IB.

Fig. 2 zeigt die Rückseiten 102 zweiter Solarzellen 10 mit einem erfindungsgemäßen Leistungshalbleiterelement 20 in einer erfindungsgemäßen Anordnung 1 in Draufsicht. Partiell dargestellt sind zwei Solarzellen 10, deren jeweilige Rückseite 102 die Anode ausbildet und eine Mehrzahl von Kontaktflächen 12, 13, 14 mit jeweils gleichem Potential auf einer Solarzelle 10. Gestrichelt dargestellt sind Kontaktflächen 16 der Solarzellen 10 auf deren Vorderseite 100, die die Kathode ausbildet.

Zur schaltungsgerechten Verbindung innerhalb eines Strings eines Photovoltaikmoduls sind die den String bildenden Solarzellen 10 seriell verschaltet. Hierzu sind Kontaktflächen 12 auf der Rückseite 102 und Kontaktflächen 16 auf der Vorderseite 100 benachbarter Solarzellen 10 mittels flächiger Metallformkörper 18, Metallbänder, miteinander verbunden.

Der Bypassstrompfad ist hier ohne weitere, zusätzlich zum erfindungsgemäßen Leistungshalbleiterelement vorhandene, Verbindungseinrichtungen vorgesehen als ein Leistungshalbleiterelement 20, das ein Kontaktelement 22 mit zwei ersten Kontaktflächen 220 zur Verbindung mit zugeordneten Kontaktflächen 13 der Rückseite der Solarzelle aufweist. Das Leistungshalbleiterelement 20 weist als Leistungshalbleiterbauelement 24 hierbei eine Schottkydiode auf, deren erste Chipkontaktfläche 240, die Anode, mit dem Kontaktelement 22 verbunden ist. Die Diode 24 ist hier nicht fluchtend zu einer Kontaktfläche 220 des Kontaktelements 22 angeordnet, sondern mittig zwischen den beiden Kontaktflächen 220 vorgesehen. Somit schwebt die Diode 24 quasi oberhalb der Solarzelle 10 und wird von dieser nicht erwärmt, wodurch die Sperrströme und somit auch die Verluste im Normalbetrieb, wenn also alle Solarzellen Strom liefern, gering sind.

Weiterhin ist die Kathode der Diode 24 mit ihrer zweiten Chipkontaktfläche 242 mit einer Kontaktfahne 28 verbunden ist. Diese Kontaktfahne 28 reicht in ihrem Verlauf zu einer benachbarten Solarzelle 10 und ist mit seiner zweiten Kontaktfläche 280 dort mit einer Kontaktfläche 14 der Rückseite 102 verbunden.

Für die elektrische Verbindung der Solarzellen 10 innerhalb eines Strings wie auch für die Verbindungen des Leistungshalbleiterelements 20 mit den Solarzellen 10 ist die gleiche Verbindungstechnologie vorgesehen. Besonders bewährt sind hier Löt- oder Klebeverfahren. Zudem ist es weiterhin vorteilhaft, wenn die Metallbänder 18 wie auch das Kontaktelement 22 und die Kontaktfahne 28 aus dem gleiche Material mit gleicher Oberflächenbeschaffenheit zumindest an den Kontaktstellen 220, 228 vorgesehen sind. Hierdurch ist die Anordnung des Leistungshalbleiterelements 20 im Rahmen der bekannten Herstellungsverfahren für Photovoltaikmodule möglich. Ebenso vorteilhaft und auch dargestellt ist, dass das das Kontaktelement (22) und die Kontaktfahne (28) in Bezug auf ihre größte Längsausdehnung senkrecht zueinander angeordnet sind.

Die hierbei verwendete Diode 24 weist auf Grund der geringen benötigten Stromträgfähigkeit nur eine Fläche von wenigen Quadratmillimetern auf. Demgegenüber weisen typische Solarzellen 10 Kantenlängen im Bereich von zehn Zentimetern auf. Die Fläche des Kontaktelements 22 des Leistungshalbleiterelements 20 kann daher im Sinne einer möglichst großen Kühlfläche wesentlich größer ausgebildet sein als die Fläche der Diode 24. Es haben sich Verhältnisse von mindestens 1 zu 10, besser von mehr als 1 zu 20 als vorteilhaft erwiesen.

Durch die oben genannte Ausgestaltung der Kontaktfahne 28 weist diese eine Länge von mehr als dem 5-fachen, besser mehr als dem 10-fachen, der Längsausdehnung der Diode 24 auf.

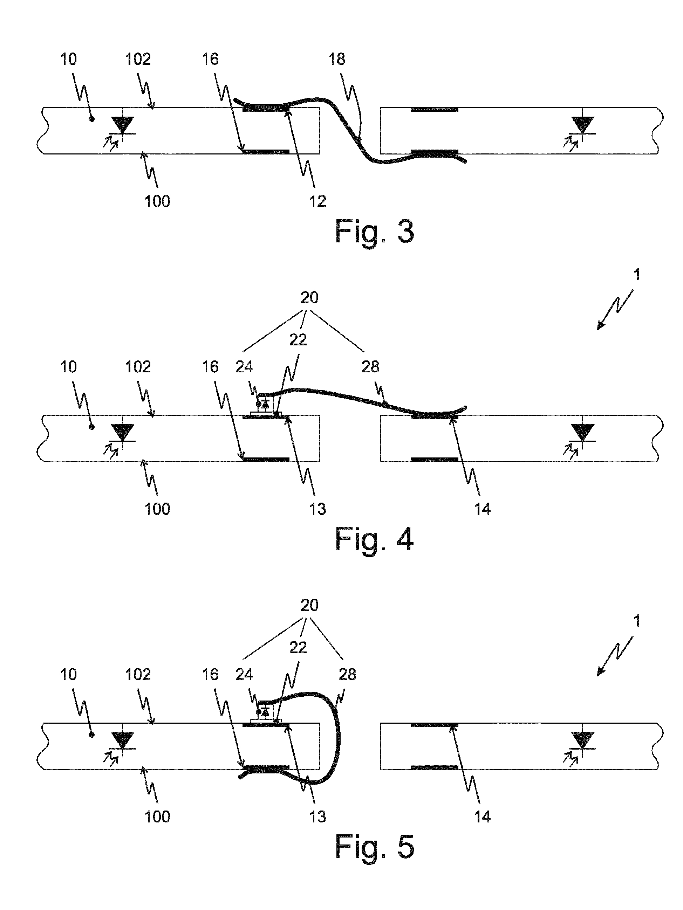

Fig. 3 zeigt in Schnittdarstellung Ausschnitte von zwei Solarzellen 10 in Reihenschaltung. Dargestellt ist die Vorderseite 100, typischerweise die Kathode und die Rückseite 102, typischerweise die Anode, der jeweiligen Solarzelle 10. Zur Reihenschaltung der beiden Solarzellen 10 ist mindesten eine Kontaktfläche 12 der Anode mit einer Kontaktfläche 16 der Kathode mittels eines Metallbandes 18 verbunden.

Fig. 4 zeigt eine erste Ausgestaltung einer erfindungsgemäßen Anordnung 1 mit einem Leistungshalbleiterelement 20 in nicht maßstäblicher und in der Tiefe, also in Richtung der Zeichnungsebene komprimierter Darstellung. Speziell soll hierunter verstanden werden soll, dass die Diode 24 wie oben beschrieben nicht mit einer der Kontaktflächen 220 des Kontaktelements 22 fluchtet, sondern aus der Zeichnungsebene nach hinten versetzt angeordnet ist, wie in Fig. 2 dargestellt. Dieser Verallgemeinerung gilt ebenso für alle weiteren Darstellungen.

Weiterhin dargestellt sind Kontaktflächen 12, 13, 14, 16 auf der Rückseite und der Vorderseite der jeweiligen Solarzelle 10, wie auch bei Fig. 2 beschrieben. Entsprechend ist weiterhin das Leistungshalbleiterbauelement 24 auf dem Kontaktelement 22 angeordnet, wobei die Anode der Diode 24 mit diesem mittels ihrer ersten Chipkontaktfläche 240 verbunden ist. Die Kathode der Diode ist mittels der zweiten Chipkontaktfläche 242 mit der Kontaktfahne 28 und diese über ihre zweite Kontaktfläche 280 mit einer Kontaktfläche 14 auf der Rückseite 102 der rechten Solarzelle 10 verbunden.

Fig. 5 zeigt eine zweite Ausgestaltung einer derartigen Anordnung 1. Diese unterscheidet sich von der ersten Ausgestaltung dadurch, dass hierbei die Kontaktfahne 28 des Leistungshalbleiterelements 20 mit einer Kontaktfläche 16 auf der Kathode, der Vorderseite 100, derjenigen Solarzelle 10 verbunden ist, die auch auf ihrer Rückseite 102 das Kontaktelement 22 mit dem Leistungshalbleiterbauelement 24 trägt.

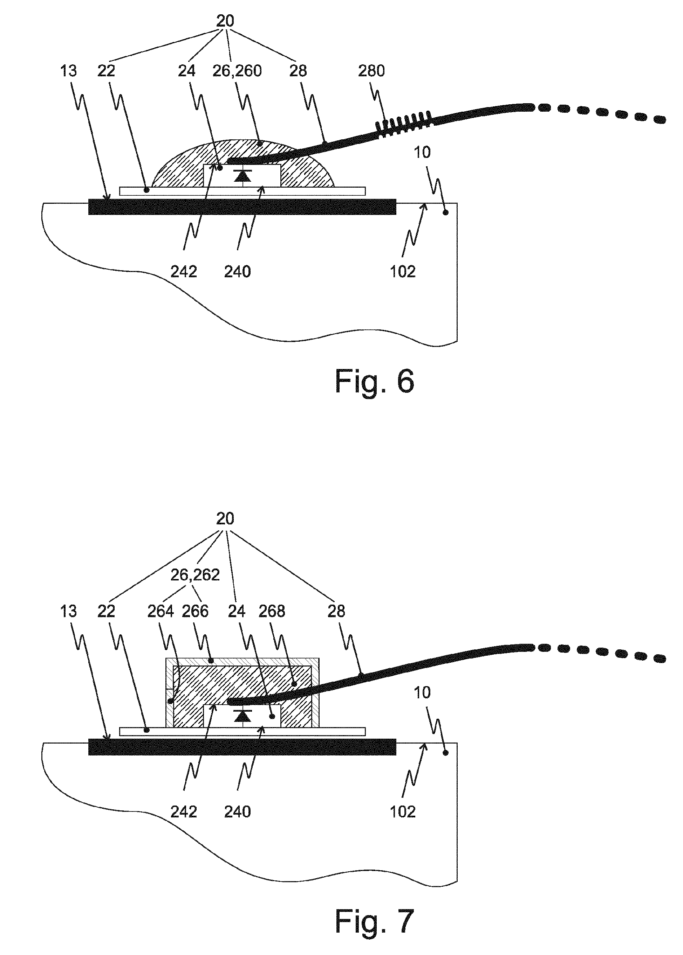

Fig. 6 zeigt eine erste Ausgestaltung eines erfindungsgemäßen Leistungshalbleiterelements 20 angeordnet auf einer Solarzelle 10 vergleichbar der linken Solarzelle in Fig. 4, wobei aus Gründen der Übersichtlichkeit, wie auch in Fig. 7, das Leistungshalbleiterelement 20 geringfügig beabstandet von der Solarzelle 10 dargestellt ist. Grundsätzlich sind die gleichen Merkmale wie Fig. 4 dargestellt und auch gleich bezeichnet. Zusätzlich ist hier eine Umhausung 26 dargestellt, die aus einem im Verarbeitungszustand fließfähigen Kunststoff 260 besteht.

Für die Anordnung dieser Umhausung 260 sind grundsätzlich verschiedene Verfahren anwendbar, wesentlich ist hierbei, dass eine Fixierung der Kontaktfahne 28 insoweit gegeben ist, dass ein elektrischer Kontakt der Kontaktfahne 28 zum Kontaktelement 22 verhindert wird.

Ebenso wesentlich ist, dass die Umhausung 260 das Leistungshalbleiterbauelement 24 vor Umwelteinflüssen schützt und hierzu eine feuchtigkeitssichere Verbindung mit dem Kontaktelement 22 eingeht.

Die Kontaktfahne 28 weist hier eine Kühleinrichtung 282 zur Kühlung des Leistungshalbleiterbauelements 24 auf, die als prägetechnisch ausgebildete Vergrößerung der Oberfläche der Kontaktfahne 28 in unmittelbarer Nähe zum Leistungshalbleiterbauelements 24 vorgesehen ist.

Fig. 7 zeigt eine zweite derartige Ausgestaltung. Hierbei besteht die Umhausung 26 im Gegensatz zu Fig. 6 aus einem hier zweiteilig ausgebildeten Isolierstoffgehäuse 262, der einen besonders guten mechanischen Schutz des Leistungshalbleiterbauelements 24 bietet.

Dieses Isolierstoffgehäuse 262 weist einen Grundkörper 264 auf, der mit dem Kontaktelement 22 stoffschlüssig und feuchtigkeitsdicht verbunden ist. Weiterhin weist das Isolierstoffgehäuse 262 einen Deckel 266 auf, der mit dem Grundkörper 264 stoffschlüssig verbunden ist und der die Kontaktfahne 28 zwischen Grundkörper 264 und Deckel 266 klemmt um einen elektrischen Kontakt mit dem Kontaktelement zu 22 verhindern.

Weiterhin ist das Isolierstoffgehäuse 262 mit einer elektrisch isolierenden Vergussmasse 268, einem Isolationsstoff, verfüllt, der gleichzeitig das Leistungshalbleiterbauelement 24 vor Feuchtigkeit schützen kann.

## Patentansprüche

1. Leistungshalbleiterelement (20) zum direkten Anschluss an Kontaktflächen einer Solarzelle mit einem Kontaktelement (22) und einer Kontaktfahne (28), jeweils mit mindestens einer zugeordneten ersten bzw. zweiten Kontaktfläche (220, 280), mindestens einem Leistungshalbleiterbauelement (24) dessen erste Chipkontaktfläche (240) mit dem Kontaktelement (22) und dessen zweite Chipkontaktfläche (242) mit der Kontaktfahne (28) verbunden ist und das gegen Umwelteinflüsse in einer Umhausung (26) des mindestens einen Leistungshalbleiterbauelements (24) eingeschlossen ist.

2. Leistungshalbleiterelement nach Anspruch 1, wobei
das Leistungshalbleiterbauelement (24) eine Schottky- oder eine Halbleiterdiode mit pn- Übergang, jeweils mit einer Anode und einer Kathode ist.

3. Leistungshalbleiterelement nach Anspruch 2, wobei
die Anode des Leistungshalbleiterbauelements (24) mit dem Kontaktelement (22) und die Kathode des Leistungshalbleiterbauelements (24) mit der Kontaktfahne (28) elektrisch leitend verbunden ist.

4. Leistungshalbleiterelement nach Anspruch 1, wobei
die Umhausung (26) aus einem im Verarbeitungszustand fließfähigen Kunststoff (260) besteht.

5. Leistungshalbleiterelement nach Anspruch 1, wobei
die Umhausung (26) aus einem ein- oder mehrteilig Isolierstoffgehäuse (262) besteht, das vorzugsweise aus einem Grundkörper (264) und einem Deckel (266), ausgebildet ist und wobei der Grundkörper (264) stoffschlüssig mit dem Kontaktelement (22) verbunden ist.

6. Leistungshalbleiterelement nach Anspruch 5, wobei
der Grundkörper (264) und der Deckel (266) stoffschlüssig miteinander verbunden sind.

7. Leistungshalbleiterelement nach Anspruch 6, wobei
das Isolierstoffgehäuse (262) mit einem Isolationsstoff (268) verfüllt ist.

8. Leistungshalbleiterelement nach Anspruch 1, wobei
das das Kontaktelement (22) und die Kontaktfahne (28) aus einem flächigen Metallformkörper, vorzugsweise einem Metallband aus Aluminium, gebildet ist.

9. Leistungshalbleiterelement nach Anspruch 8, wobei
das das Kontaktelement (22) und die Kontaktfahne (28) in Bezug auf ihre größte Längsausdehnung senkrecht zueinander angeordnet sind.

10. Leistungshalbleiterelement nach Anspruch 1, wobei
das Kontaktelement (22) und / oder die Kontaktfahne (28) mindestens eine einstückig damit ausgebildete Kühleinrichtung (280) aufweist.

11. Leistungshalbleiterelement nach Anspruch 1, wobei
das Leistungshalbleiterbauelement (24) maximal 10 von 100, vorzugsweise maximal 5 von 100 der Fläche des Kontaktelements (22) bedeckt.

12. Anordnung (1) eines Leistungshalbleiterelement (20) nach einem der Ansprüche 1 bis 11 zu mindestens einer Solarzelle (10), wobei
das Kontaktelement (22) auf der Rückseite (102) der Solarzelle (10) angeordnet und mittels seiner mindestens einen ersten Kontaktfläche (220) mit mindestens einer Kontaktfläche (13) der Rückseite (102) der Solarzelle (10) elektrisch verbunden ist und wobei die mindestens eine zweite Kontaktfläche (280) die Kontaktfahne (28) entweder
mit mindestens einer Kontaktfläche (16) des Vorderseite (100) der gleichen Solarzelle (10) oder
mit mindestens einer Kontaktfläche (14) der Rückseite (102) einer weiteren Solarzelle (10) elektrisch leitend verbunden ist und somit einen Bypassstrompfad für eine oder eine Mehrzahl von Solarzellen (10) ausbildet.

13. Anordnung nach Anspruch 12, wobei
die Rückseite (102) der Solarzelle (10) deren Anode und die Vorderseite (100) der Solarzelle (10) deren Kathode ausbildet.

14. Anordnung nach Anspruch 12, wobei
die Kontaktfahne (28) des Leistungshableiterelements (20) identische zu denjenigen flächigen Metallformkörpern (18) ausgebildet ist, die die Reihenschaltung der Solarzellen (10) miteinander ausbilden.

15. Anordnung nach Anspruch 12, wobei
das mindestens eine Leistungshalbleiterbauelement (24) nicht fluchtend zu einer ersten Kontaktfläche (220) des Kontaktelements (22) angeordnet ist.
